Europäisches Patentamt

(19) **European Patent Office**

**Office européen des brevets**

(11) Numéro de publication: **0 171 629**
**B1**

(12) # FASCICULE DE BREVET EUROPÉEN

(45) Date de publication du fascicule du brevet: 21.03.90

(51) Int. Cl. $^5$: **H 02 J 9/00**, G 01 R 31/36

(21) Numéro de dépôt: 85108873.2

(22) Date de dépôt: 16.07.85

(54) Dispositif de test d'autonomie pour bloc d'éclairage de sécurité.

(30) Priorité: 18.07.84 FR 8411400

(43) Date de publication de la demande:
19.02.86 Bulletin 86/08

(45) Mention de la délivrance du brevet:
21.03.90 Bulletin 90/12

(84) Etats contractants désignés:
AT BE CH DE FR GB IT LI LU NL SE

(56) Documents cité:
EP-A-0 030 154
DE-A-2 851 599
FR-A-2 425 159
FR-A-2 477 282
GB-A-2 016 223

(73) Titulaire: Société Anonyme dite SAFT
156, avenue de Metz
F-93230 Romainville (FR)

(72) Inventeur: Mangez, Jean-Claude
2, boulevard Gambetta
F-93130 Noisy Le Sec (FR)

(74) Mandataire: Weinmiller, Jürgen
Lennéstrasse 9 Postfach 24
D-8133 Feldafing (DE)

LIBERGRAF, STOCKHOLM 1990

## Description

La présente invention concerne les blocs d'éclairage de sécurité destinés à maintenir un éclairage de sécurité dans des locaux en cas de défaillances de l'éclairage normal dues à une coupure du réseau d'alimentation normale en énergie électrique.

Ces blocs d'éclairage de sécurité se composent en général d'une batterie d'accumulateurs Ni Cd pourvue d'un dispositif de charge à courant constant et d'une lampe d'éclairage de sécurité, en général doublée, connectée aux bornes de la batterie d'accumulateurs au moyen d'un interrupteur commandé par un circuit de gestion du bloc qui le ferme lorsque l'alimentation normale disparait et que la batterie d'accumulateurs délivre une tension supérieure à un seuil minimal.

On doit effectuer régulièrement différents tests sur ces blocs d'éclairage de sécurité de manière à vérifier qu'ils sont à tout moment en état d'assurer leur fonction d'éclairage de sécurité, notamment:

- des tests de la charge effective de la batterie d'accumulateurs,
- des tests de l'état des lampes destinées à l'éclairage de sécurité,
- des tests du passage de l'état de veille à l'état de fonctionnement (allumage à la disparition de l'alimentation normale),
- des tests d'autonomie (durée effective de l'éclairage de sécurité en l'absence de l'alimentation normale).

Pour les trois premières sortes de tests des moyens simples et efficaces sont prévus dans les blocs d'éclairage de sécurité. Certains, équipés de·lampes de sécurité à filaments, sont pourvus d'une lampe témoin qui est placée en série avec les lampes de sécurité sur le trajet d'une partie du courant de charge de la batterie d'accumulateurs et qui est allumée à l'état de veille sauf en cas d'annulation du courant de charge de la batterie d'accumulateurs ou de rupture des filaments des lampes de sécurité. D'autres sont pourvus d'un bouton poussoir de test non maintenu permettant de simuler une coupure de l'alimentation normale et, par conséquent, de vérifier manuellement et localement leur allumage, allumage qui atteste du bon état de l'ensemble des lampes de sécurité et de la présence d'une tension suffisante aux bornes de la batterie d'accumulateurs.

Il est connu par le document DE-A-2 851 599 un moyen de test automatique d'une batterie d'une alimentation de secours qui, sous la commande d'un interrupteur, commute la batterie sur une résistance de décharge et mesure son temps de décharge en veillant à ce que la tension de la batterie se maintienne au-dessus d'un certain seuil, le test s'arrêtant dès que la tension de la batterie franchit le seuil ou à la fin de la durée théorique d'autonomie de la batterie.

Par contre, aucun moyen spécifique n'est prévu pour tester l'autonomie effective des batteries d'accumulateurs des blocs d'éclairage de sécurité. La procédure de test utilisée consiste à couper volontairement l'alimentation normale de l'installation équipée des blocs d'éclairage de sécurité et à vérifier, au bout d'un temps de coupure égal à l'autonomie des blocs que ces derniers sont encore en état de fonctionnement. Cette procédure de test n'est pas toujours utilisable car l'alimentation normale des blocs de sécurité est en dérivation sur celle de l'éclairage normal qui ne peut être arrêtée dans les locaux occupés en permanence. Elle est en outre difficile à mettre en oeuvre car la répartition géographique des blocs d'éclairage de sécurité d'une installation même subdivisée en zones ne permet que rarement de vérifier le bon fonctionnement de l'ensemble des blocs, cette vérification devant être faite dans un délai assez court correspondant à l'incertitude tolérée sur le temps d'autonomie. Ainsi une incertitude de 5 % sur une autonomie d'une heure ne représente qu'un délai de trois minutes.

La présente invention a pour but un dispositif de test d'autonomie pour bloc d'éclairage de sécurité qui soit simple et peu coûteux et qui permette la réalisation d'un test d'autonomie sans coupure de l'alimentation du bloc et le traitement en temps différé du résultat du test sans pour autant perturber le fonctionnement normal du bloc.

Elle a pour objet un dispositif de test d'autonomie pour bloc d'éclairage de sécurité pourvu d'au moins une lampe d'éclairage de sécurité, d'une batterie d'accumulateurs destinée à alimenter la lampe d'éclairage de sécurité, d'un circuit de charge de la batterie d'accumulateurs connecté à une alimentation dite normale dont la coupure doit entraîner l'allumage du bloc d'éclairage de sécurité, d'un interrupteur commandé connectant la lampe d'éclairage de sécurité aux bornes de la batterie d'accumulateurs et d'un dispositif de gestion du bloc contrôlant l'interrupteur commandé et le fermant lorsque l'alimentation normale disparaît et que la batterie d'accumulateurs délivre une tension supérieure à un seuil minimum. Ce dispositif de test comporte un compteur de temps déclenchable, un circuit de réception d'ordre de test d'autonomie accessible par une entrée de télécommande qui est commune au circuit de gestion de bloc et qui permet à la fois de télécommander l'extinction et le réallumage du bloc d'éclairage pendant une coupure de l'alimentation normale et, à l'aide d'un ordre spécifique, de déclencher le compteur de temps, un circuit de simulation contrôlé par le compteur de temps qui, pendant le fonctionnement de ce dernier simule, pour le circuit de gestion de bloc une coupure de l'alimentation normale, un circuit de visualisation de la durée de fonctionnement du compteur de temps en l'absence d'une ouverture de l'interrupteur commandé.

Selon un mode préféré de réalisation, le compteur de temps est muni d'un circuit d'alimentation branché sur l'alimentation normale et secouru par la batterie d'accumulateurs du bloc d'éclairage de sécurité.

D'autres caractéristiques et avantages de l'invention ressortiront de la description ci-après d'un mode de réalisation de l'invention donné à titre d'exemple. Cette description sera faite en regard du dessin dans lequel:

- la figure 1 représente, de manière schématique, un bloc d'éclairage de sécurité télécommandable pourvu d'un dispositif de test selon l'inventior,
- la figure 2 détaille le circuit électrique du bloc d'éclairage de sécurité de la figure 1 avec ses points d'interconnexion au dispositif de test,
- la figure 3 détaille le schéma électrique du dispositif de test de la figure 1 et ses points d'interconnexion avec le circuit électrique du bloc d'éclairage de sécurité représenté à la figure 2,
- la figure 4 représente une variante de réalisation du circuit de réception d'ordre de test d'autonomie appartenant au dispositif de test de la figure 3,
- la figure 5 représente une variante de réalisation du circuit d'affichage du dispositif de test représenté à la figure 3,
- la figure 6 est une variante relative au mode de déclenchement du dispositif de test d'autonomie précité et,
- la figure 7 est une variante relative aux commandes du circuit électrique du bloc d'éclairage de sécurité de la figure 2 à partir du dispositif de test d'autonomie précité, permettant une modification des conditions de test pour l'effectuer en vraie grandeur.

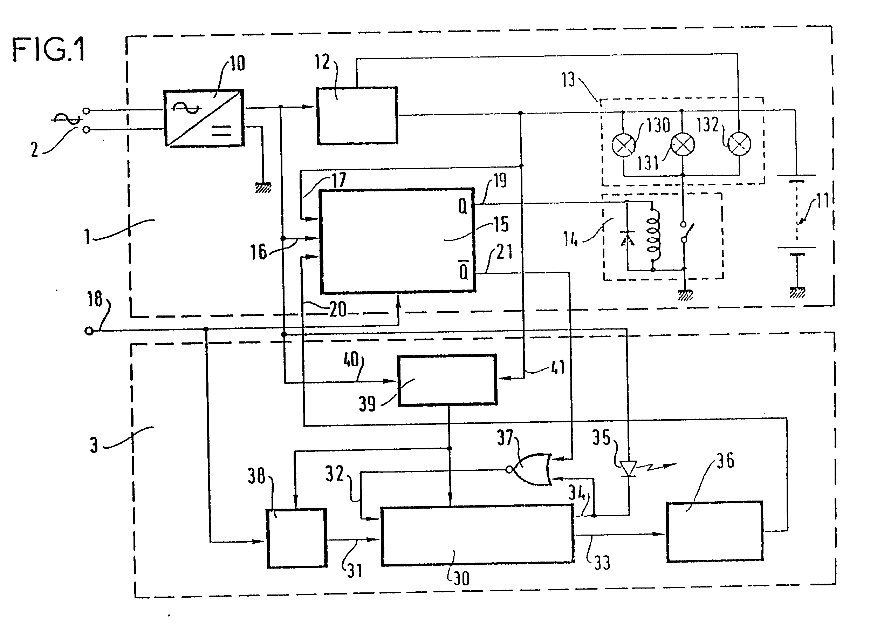

On distingue sur la figure 1, un bloc d'éclairage de sécurité 1 alimenté par le secteur 2 qui constitue la source d'alimentation normale et équipé d'un dispositif de test d'autonomie 3.

Le bloc d'éclairage de sécurité 1 comporte:

- un circuit d'alimentation 10 redressant la tension alternative du secteur 2 et la transformant en une tension continue de valeur adéquate,
- une batterie d'accumulateurs 11 avec son circuit de charge 12 alimenté par la tension continue délivrée par le circuit d'alimentation 10,
- un ensemble de lampes 13 dont deux d'éclairage de sécurité 130, 131 sont branchées aux bornes de la batterie d'accumulateurs 11 par l'intermédiaire d'un interrupteur commandé 14 et dont une troisième de test 132 placée en série avec les lampes d'éclairage de sécurité 130, 131 en dérivation partielle sur le circuit de charge 12 atteste lorsqu'elle est allumée du bon état de l'une au moins des lampes d'éclairage de sécurité 130, 131 et de la charge effective de la batterie d'accumulateurs 11
- et un circuit de gestion de bloc 15 contrôlant l'interrupteur commandé 14 de manière à le fermer et allumer les lampes d'éclairage de sécurité lorsque la tension du circuit d'alimentation 10 disparaît et que la tension délivrée par la batterie d'accumulateurs 11 est supérieure à une valeur minimum.

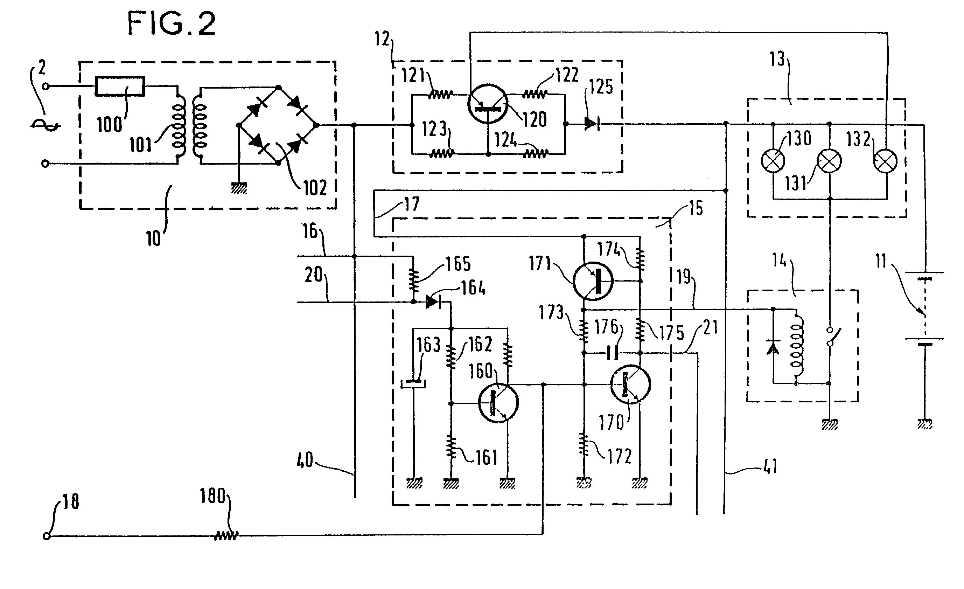

Le circuit de gestion de bloc 15 qui sera décrit dans le détail en regard de la figure 2 comporte une entrée 16 de surveillance de la tension de la source d'alimentation normale connectée en sortie du circuit d'alimentation 10, une entrée 17 de surveillance de la tension de la batterie d'accumulateurs, une entrée de télécommande 18 permettant à volonté, d'éteindre et de réallumer le bloc d'éclairage de sécurité pendant une coupure de l'alimentation normale et une sortie 19 de commande du relais constituant l'interrupteur commandé 14.

Il est en outre pourvu, pour les besoins du dispositif de test 3, d'une entrée d'inhibition 20 permettant de forcer à zéro son entrée 16 de surveillance de la tension d'alimentation normale et d'une sortie complémentée 21.

Le dispositif de test 3 comporte:

- un compteur de temps 30 avec une entrée de déclenchement 31, une entrée de blocage 32, une sortie d'état 33 qui délivre un signal binaire représentatif de l'état de marche ou d'arrêt du compteur de temps et une sortie de visualisation 34 excitant un voyant 35 au bout d'une certaine durée de fonctionnement du compteur coïncidant avec la durée du test d'autonomie,
- un circuit de simulation 36 qui est commandé par la sortie d'état 33 du compteur de temps et agit sur l'entrée d'inhibition 20 du circuit de gestion de bloc 15 de manière à simuler pour ce dernier une coupure de la tension de l'alimentation normale lorsque le compteur de temps 30 fonctionne,
- une porte logique 37 de type "non ou" à deux entrées connectée en sortie à l'entrée de blocage du compteur de temps 30 et, en entrée, à la sortie de visualisation 34 du compteur de temps ce qui transforme ce dernier en minuterie et, à la sortie complémentée 21 du circuit de gestion de bloc 15 ce qui permet de bloquer le compteur de temps en cas d'ouverture de l'interrupteur commandé 14,
- un circuit de réception d'ordre de télécommande 38 relié en entrée à l'entrée de télécommande 18 du bloc d'éclairage de sécurité, et en sortie à l'entrée de déclenchement 31 du compteur de temps 30 et
- un circuit d'alimentation 39 branché en 40 sur l'alimentation normale et en 41 sur la batterie d'accumulateurs 11 qui le secourt en cas de coupure du secteur.

La figure 2 détaille un mode de réalisation du bloc d'éclairage de sécurité 1 de la figure précédente. Son circuit d'alimentation 10 connecté au secteur 2 comprend un fusible de protection 100, un transformateur d'isolement et d'adaptation de tension 101 et un pont redresseur 102.

Le circuit de charge 12 de la batterie d'accumulateurs 11 renferme un transistor de type PNP 120 monté en source de courant grâce à des résistances 121, 122, 123, 124 et placé en série avec une diode antiretour 125. Le transistor 120 maintient une tension sensiblement constante aux bornes de sa résistance d'émetteur 121 qui se trouve de ce fait traversée par un courant constant. Ce courant constant sert à la charge de la batterie d'accumulateurs 11 à laquelle il parvient selon un trajet principal empruntant le transistor 120, sa résistance de collecteur 122 et la diode d'isolement 125 et selon un trajet de dérivation empruntant la lampe test 132 et les deux lampes de sécurité 130 et 131. Le passage du courant de charge dans le trajet de dérivation provoque l'allumage de la lampe de test et assure ainsi un auto-test de la charge de la batterie d'accumulateurs 11 et du bon état des lampes d'éclairage de sécurité 130 et 131.

Le circuit de gestion du bloc 15 comporte un circuit de détection de coupure de l'alimentation normale contrôlant une bascule bistable repositionnable.

Le circuit de détection de coupure de l'alimentation normale est formé d'un transistor 160 de type NPN monté en émetteur commun, polarisé par un pont diviseur de tension à résistances 161, 162 et alimenté aux bornes d'un condensateur 163 chargé par l'intermédiaire d'une diode antiretour 164 et d'une résistance 165 par la tension disponible en sortie du circuit d'alimentation 10 branché sur le secteur 2. En présence du secteur le condensateur 163 se charge suffisamment pour polariser le transistor 160 à saturation et lui imposer une tension collecteur proche de zéro. En cas de coupure du secteur, le condensateur 163 se décharge au travers du circuit collecteur émetteur du transistor 160 jusqu'à ce que ce dernier se bloque; il apparaît alors une pointe de tension au collecteur du transistor 160 qui est utilisée pour faire changer d'état la bascule bistable. La résistance 165 placée devant la diode 164 limite le courant de charge de la capacité 163 et permet en outre la mise à la masse de l'anode de la diode 164 par l'entrée d'inhibition 20 pour simuler une coupure de l'alimentation normale sans, pour autant, court-circuiter la sortie du circuit d'alimentation 10.

La bascule bistable est formée de deux transistors complémentaires 170, 171 montés en émetteur commun aux bornes de la batterie d'accumulateurs 11 contrôlant chacun par leur collecteur un pont résistif 172, 173 ou 174, 175 assurant la polarisation base de l'autre de manière à être simultanément bloqués ou saturés. Le collecteur du transistor 171 de type PNP constitue la sortie 19 du circuit de gestion de bloc qui commande l'excitation du relais fermant l'interrupteur commandé 14 tandis que le collecteur de l'autre transistor 170 de type NPN constitue la sortie complémentée 21 du circuit de gestion de bloc utilisée pour le contrôle du blocage du compteur de temps du dispositif de test.

Le circuit de détection de coupure de l'alimentation normale contrôle la polarisation de la base du transistor 170 de la bascule.

En présence de l'alimentation secteur, le circuit de détection de coupure de l'alimentation normale impose à la base du transistor 170 de la bascule une tension proche de zéro qui a pour effet de bloquer ce transistor 170 et par voie de conséquence l'autre transistor 171 de la bascule. Le transistor 171 étant bloqué, la bobine du relais de l'interrupteur commandé 14 n'est pas alimentée; ce dernier est ouvert et les lampes de sécurité 130, 131 ne sont pas branchées aux bornes de la batterie d'accumulateurs 11. Le bloc d'éclairage de sécurité est en état de veille, avec ses lampes d'éclairage de sécurité éteintes et sa batterie recevant le courant de charge.

En cas de coupure de l'alimentation secteur, le circuit de détection de coupure de l'alimentation normale engendre sur sa sortie une impulsion de tension positive qui sature le transistor 170 de la bascule ce qui provoque la saturation du transistor 171 et l'excitation de la bobine du relais de l'interrupteur commandé 14 qui se ferme branchant les lampes de sécurité 130, 131 aux bornes de la batterie d'accumulateurs 11 et faisant passer le bloc d'éclairage de sécurité à l'état de fonctionnement, avec ses lampes d'éclairage de sécurité allumées.

Une fois la coupure de l'alimentation secteur établie et l'impulsion de tension positive écoulée la sortie du circuit de détection de coupure de l'alimentation normale présente une impédance suffisante pour ne pas provoquer le reblocage du transistor 170 maintenu à la saturation par l'autre transistor 171. Les deux transistors 170 et 171 de la bascule restent à l'état saturé maintenant le bloc d'éclairage de sécurité dans son état de fonctionnement.

Plus la coupure de l'alimentation secteur se prolonge, plus la batterie d'accumulateurs 11 se décharge et la tension d'alimentation de la bascule décroît entrainant une diminution de la polarisation à saturation des deux transistors 170 et 171 de la bascule. En deçà d'un certain seuil de tension, ces deux transistors 170 et 171 qui ne peuvent plus se maintenir mutuellement saturés, se bloquent entrainant l'arrêt de l'excitation de la bobine du relais de l'interrupteur commandé 14 qui s'ouvre provoquant l'extinction des lampes d'éclairage de sécurité 130, 131 et faisant passer le bloc d'éclairage de sécurité à l'état de repos (lampes de sécurité éteintes en l'absence de la source d'alimentation normale).

L'entrée de télécommande 18 est connectée par une résistance 180 à la base du transistor 170 de la bascule bistable du circuit de gestion de bloc 15. Elle permet, en l'absence d'alimentation secteur de bloquer ou de saturer le transistor 170 en absorbant ou en injectant par la résistance 180 un courant dans la jonction base émetteur de ce transistor et par conséquent de contrôler l'état de la bascule c'est-à-dire l'état de fonctionnement ou de repos du bloc d'éclairage de sécurité.

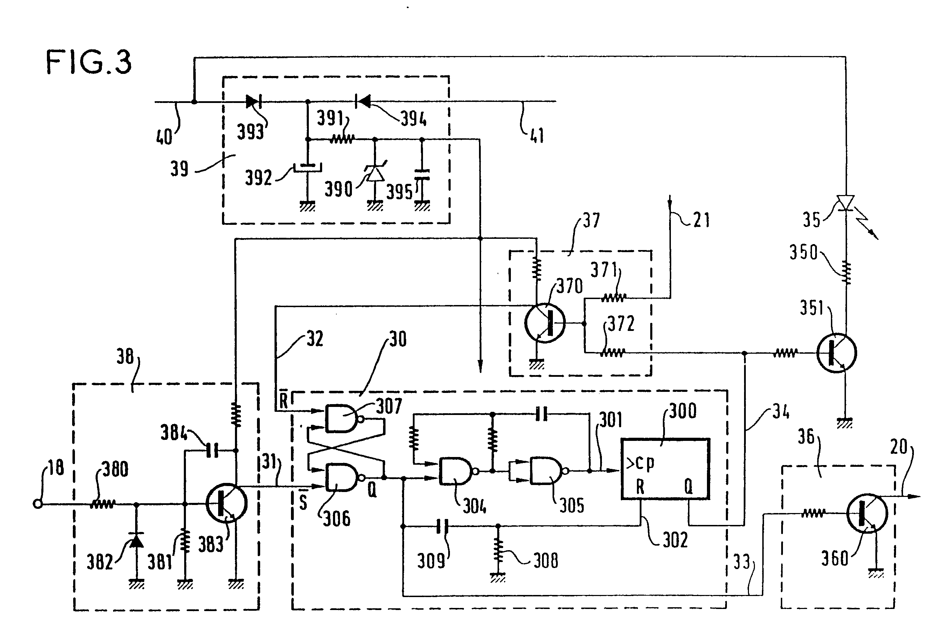

La figure 3 détaille un mode de réalisation du dispositif de test d'autonomie 3 de la figure 1.

Dans ce dispositif de test, le compteur de temps 30 est réalisé à partir d'un compteur numérique 300, d'un oscillateur blocable formé de deux portes logiques de type "et non" 304, 305 placées en régime oscillant par un réseau de résistances et de capacité et d'une bascule bistable de type R̄ S̄ formée de deux portes logiques de type "et non" 306, 307.

Le compteur numérique 300 présente une entrée de comptage 301, une entrée de remise à zéro 302 sensible à des impulsions positives et une sortie dont le bit de plus fort poids constitue celle de visualisation 34 du compteur de temps 30.

La bascule bistable de type R̄ S̄ détermine l'état de blocage ou de déblocage du compteur de temps 30. Elle est connectée par sa sortie Q qui constitue la sortie d'état 33 du compteur de temps 30 à la commande de blocage ou de déblocage de l'oscillateur, au circuit de simulation 36 et, par l'intermédiaire d'un générateur d'impulsion à résistance 308 et capacité 309, à l'entrée de remise à zéro du compteur numérique 300. Son entrée S̄ constitue l'entrée de déclenchement 31 du compteur de temps 30 tandis que son entrée R̄ constitue celle de blocage 32 du compteur de temps 30. Le passage de sa sortie Q du niveau logique 0 au niveau logique 1 débloque l'oscillateur et provoque l'apparition d'une impulsion positive remettant à zéro le compteur numérique 300 tandis que le passage inverse du niveau logique 1 au niveau logique 0 bloque l'oscillateur et engendre une impulsion négative sans effet sur la remise à zéro du compteur numérique 300.

La porte logique de type "non ou" 37 à deux entrées qui transforme le compteur de temps 30 en minuterie tout en permettant son blocage en l'état par l'arrêt du bloc d'éclairage de sécurité est formé, classiquement, par un transistor 370 monté en émetteur commun et attaqué par deux résistances 371, 372 reliant sa base, l'une à la sortie de visualisation 34 du compteur de temps 30 et l'autre à la sortie complémentée 21 du circuit de gestion de bloc.

Le circuit de simulation 36 est réalisé à l'aide d'un transistor 360 monté en interrupteur entre la masse et l'entrée d'inhibition 20 du circuit de gestion de bloc.

Le circuit de réception d'ordre de télécommande 38 est formé d'un pont résistif diviseur de tension 380, 381 connecté entre la masse et l'entrée de télécommande 18, pourvu d'une diode 382 de protection en inverse et suivi d'un étage à transistor 383 monté en émetteur commun.

Le voyant 35 est une diode électroluminescente alimentée par le secteur et, placée en série avec une résistance de limitation de courant 350 et l'espace collecteur émetteur d'un transistor 351 commandé en interrupteur par la sortie de visualisation 34 du compteur de temps 30 entre la masse et la sortie 40 du circuit d'alimentation du bloc d'éclairage de secours.

Le circuit d'alimentation 39 du dispositif de test comporte un ensemble de régulation de tension formé par une diode Zener 390 connectée en série avec une résistance 391 aux bornes d'un condensateur de filtrage 392 chargé, en cas d'alimentation normale, par le secteur grâce à une diode 393 le reliant à la sortie 40 du circuit d'alimentation du bloc d'éclairage de secours et, en cas d'absence d'alimentation normale, par la batterie d'accumulateurs 11 du bloc d'éclairage de secours grâce à une diode 394 raccordée en 41 sur cette dernière. Le dispositif de test est ainsi constamment alimenté quel que soit l'état de veille, fonctionnement ou de repos du bloc d'éclairage de sécurité, soit par l'énergie fournie par l'alimentation normale, soit par celle, même résiduelle, de la batterie d'accumulateurs après une autonomie complète.

Le transistor 383 du circuit de réception d'ordre de télécommande de test est bloqué en l'absence de tension sur l'entrée de télécommande 18 ou en présence sur cette entrée de télécommande 18 d'impulsions de télécommande d'extinction du bloc d'éclairage de sécurité ou de réallumage car les premières sont de polarité négative et les secondes de tension insuffisante par exemple 12 volts pour débloquer la jonction émetteur base du transistor 383 par l'intermédiaire du pont diviseur résistif 380, 381. Par contre, ce transistor 383 se sature lors de l'application sur l'entrée de télécommande d'une impulsion de télécommande de test de même polarité qu'une télécommande de réallumage du bloc mais de tension suffisante par exemple 24 volts pour engendrer en sortie du circuit de réception d'ordre de télécommande de test 38 un niveau logique 0 déclenchant le test d'autonomie.

Ce niveau logique 0 entraîne en effet le passage au niveau logique 1 de la sortie Q de la bascule R̄ S̄ formée par les portes logiques 306, 307 ce qui a pour effet:

- l'envoi d'une impulsion positive par le réseau à résistance et capacité 308, 309 à l'entrée de remise à zéro du compteur numérique 300 dont la sortie, y compris son bit de plus fort poids passe à zéro,
- la mise en conduction du transistor 360 du circuit de simulation 36,
- le déblocage de l'oscillateur formé des portes logiques 304, 305.

Le passage au niveau logique 0 s'il n'y était pas déjà du bit de plus fort poids de la sortie du compteur numérique 300 bloque le transistor 351 et éteint la diode électroluminescente du voyant 35 de test d'autonomie.

La mise en conduction du transistor 360 du circuit de simulation 36 simule pour le circuit de gestion du bloc d'éclairage de sécurité une coupure de l'alimentation normale de sorte que les transistors complémentaires 170, 171 (figure 2) de ce dernier passent s'ils ne l'étaient pas déjà à l'état de conduction et excitent la bobine du relais constituant l'interrupteur commandé 14 (figure 2) qui se ferme et provoque l'allumage des lampes d'éclairage de sécurité 130, 131 à partir de la batterie d'accumulateurs. Le bloc d'éclairage de sécurité passe en état de fonctionnement.

Dans le cas où le bloc était à l'état de repos lors de la réception de l'ordre de test le passage à l'état de fonctionnement est directement provoqué par la polarisation du transistor 170 par la résistance 180 et la mise en conduction du transistor 360 interdit le retour à l'état de veille en cas de rétablissement de l'alimentation normale en cours de test d'autonomie.

Le passage à l'état de conduction du transistor 170 du circuit de gestion du bloc d'éclairage de sécurité fait passer la sortie complémentée 21 du circuit de gestion de bloc au niveau logique 0 ce qui fait basculer au niveau logique 1 la sortie de la porte logique "non ou" 37 (figure 1) qui maintient en l'état la bascule de type R̄ S̄ formée par les portes logiques 306, 307, même après retour au niveau logique 1 de la sortie du circuit de réception d'ordre de télécommande 39.

Le déblocage de l'oscillateur formé par les portes logiques 306, 307 entraine l'émission d'impulsions périodiques comptées par le compteur numérique 300 qui ayant été remis à zéro en début de test comptabilise le temps écoulé.

La fin du test peut être provoquée par le fait que le test s'est déroulé sur la durée prévue ou bien par le fait que la batterie d'accumulateurs arrive en fin de décharge.

L'écoulement du temps correspondant à la durée prévue pour le test est attesté par le passage du bit de plus fort poids de la sortie du compteur numérique 300 à l'état logique 1, la fréquence de l'oscillateur et la capacité du compteur numérique ayant été choisies en conséquence tandis que la fin de décharge de la batterie d'accumulateurs est attestée par le passage au niveau logique 1 de la sortie complémentée 21 du circuit de gestion de bloc, ce passage étant dû au blocage des transistors complémentaires 170, 171 par suite d'une polarisation insuffisante par la batterie d'accumulateurs.

Ces deux événements provoquent l'un comme l'autre l'application d'un niveau logique 0 par la porte logique de type "non ou" 37 sur l'entrée R̄ de la bascule R̄ S̄ du compteur de temps 30. Comme l'entrée S̄ de la bascule de type R̄ S̄ est repassée au niveau logique 1 après la fin de réception d'un ordre de télécommande de test, sa sortie passe au niveau logique 0 bloquant à la fois le circuit de simulation 36 et l'oscillateur formé des portes logiques 304 et 305.

Le blocage du circuit de simulation 36 permet au condensateur 163 (figure 2) du circuit de gestion de bloc de se recharger et de débloquer le transistor 160 qui commande le blocage, s'il ne l'était pas déjà, des transistors complémentaires 170 et 171, l'arrêt d'excitation du relais de l'interrupteur commandé 14 et donc l'extinction des lampes d'éclairage de sécurité. Le bloc d'éclairage de sécurité revient à l'état de veille et la batterie repart en charge.

Le blocage de l'oscillateur formé des portes logiques 304 et 305 laisse le compteur numérique 300 en l'état. Deux cas sont possible:

— la fin du test a été provoquée par le circuit de gestion du bloc. Le digit de plus fort poids de la sortie du compteur numérique 300 est resté au niveau logique 0 montrant que l'autonomie réelle du bloc d'éclairage de sécurité n'atteint pas l'autonomie nominale. La diode électroluminescente du voyant 35 n'est pas alimentée et reste éteinte témoignant d'un test négatif,

— la fin du test a été provoquée par le passage au niveau logique 1 du digit de plus fort poids de la sortie du compteur numérique 300 montrant que le test s'est prolongé sur la durée voulue sans atteindre la fin de décharge de la batterie d'accumulateurs. Le transistor 351 est alors saturé et la diode électroluminescente du voyant 35 allumée en présence d'alimentation normale témoignant d'un test positif.

L'état de la diode électroluminescente du voyant 35 reste inchange entre deux tests d'autonomie.

Les tests d'autonomie s'effectuent normalement en présence de l'alimentation normale et il faut tenir compte, pour déterminer la durée maximale du test, du fait que la batterie d'accumulateurs du bloc continue à être chargée alors qu'elle ne l'est pas lorsque le bloc d'éclairage de secours est en marche normale. Cette durée maximale de test doit alors être supérieure à la durée d'autonomie nominale du bloc de l'ordre de 10 à 30 % pour les batterie d'accumulateurs recevant un courant de charge correspondant à une charge en 24 heures et se déchargeant en 1 à 3 heures dans les lampes de sécurité.

Le test d'autonomie n'est valable que si la totalité des lampes d'éclairage de sécurité est en état de fonctionnement, si l'alimentation normale a été présente suffisamment longtemps entre la dernière autonomie et le début du test, si le test n'a pas été annulé avant son terme par une télécommande d'extinction.

Il reste valable, en cas de coupure effective de l'alimentation normale aux erreurs près dues à l'annulation du courant de charge batterie qui en résulte, sauf dans le cas où cette charge batterie est bloquée durant le test.

Si l'arrêt d'un test en cours, par une télécommande d'extinction, est interdit, il est nécessaire de bloquer les impulsions de télécommande durant le test par exemple à l'aide d'un transistor monté en interrupteur commandé placé en série avec la résistance 180 et commandé en sens inverse du circuit de simulation 36.

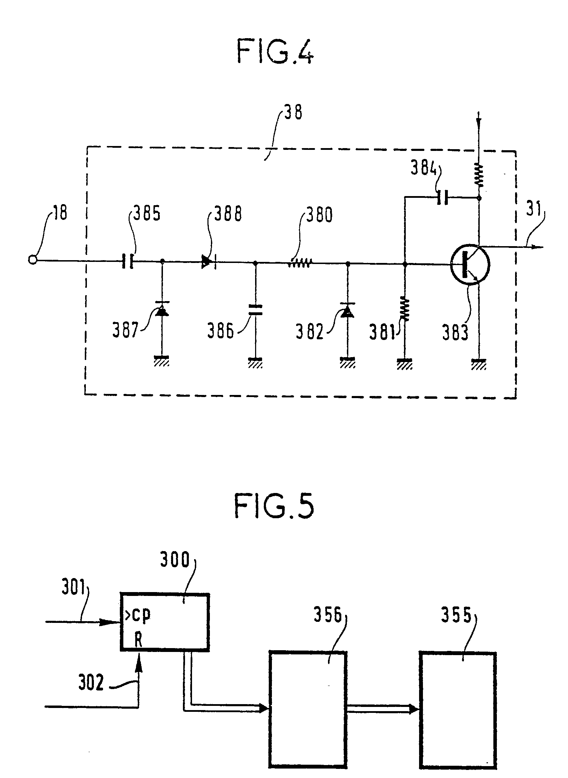

La discrimination entre les télécommandes d'extinction, de réallumage et de test d'autonomie peut se faire autrement que sur des amplitudes d'impulsions. On peut notamment adopter pour l'ordre de test d'autonomie, une impulsion de même polarité et de même amplitude que l'ordre de réallumage du bloc mais de durée plus importante. Il suffit pour cela d'augmenter fortement la capacité d'un condensateur 384 (figure 3) placé à l'origine dans un but d'antiparasitage entre la base et le collecteur du transistor 383 du circuit de réception d'ordre de télécommande de test 38. On peut également utiliser une tension alternative pour télécommander le test d'autonomie. Dans ce cas, le circuit de réception d'ordre de télécommande de test est modifié conformément à la figure 4 par l'insertion devant le pont résistif diviseur de tension 380, 381 commandant la base du transistor 383, d'un pont redresseur doubleur de tension formé des condensateurs 385, 386 et des diodes 387, 388. Le circuit de gestion du bloc d'éclairage de sécurité est protégé contre les effets de la tension alternative appliquée à l'entrée de télécommande pour provoquer un test d'autonomie par un condensateur d'antiparasitage 176 (figure 2) placé dans sa bascule à transistors complémentaires, en parallèle sur la jonction base collecteur du transistor 170.

Au lieu de se limiter à la simple constatation du fait qu'un bloc d'éclairage de sécurité tient l'autonomie nominale, on peut souhaiter connaître son autonomie réelle. Dans ce cas, il suffit d'ouvrir la boucle de rétroaction transformant le compteur de temps 30 en minuterie en déconnectant la porte logique "non ou" 37 de la sortie de visualisation 34 du compteur de temps et en mettant l'entrée libérée en parallèle sur l'autre, et de remplacer le voyant 35 par un dispositif de visualisation de l'état du compteur numérique 300 tel que, par exemple celui représenté en figure 5 avec un afficheur 7 segments ou autre 355 connecté par l'intermédiaire d'un décodeur 356 à l'ensemble des bits de la sortie du compteur numérique 300, l'afficheur 355 étant alimenté de la même manière que le voyant, sans être secouru par la batterie d'accumulateurs.

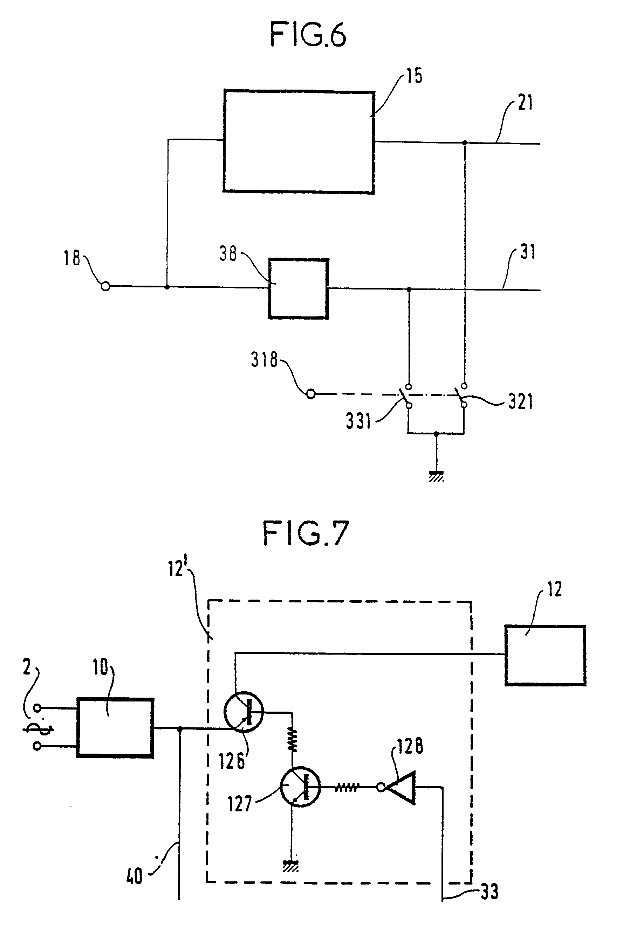

Le test d'autonomie peut également être déclenché par une commande locale ou rapprochée ainsi que représenté dans la figure 6. Pour un tel mode de déclenchement, au dispositif de test 3 sont associés deux éléments de commande 331 et 321 fonctionnant en interrupteurs normalement ouverts commandés simultanément en fermeture momentannée, ainsi que schématisé par une entrée de commande 318, pour déclencher un test d'autonomie du bloc d'éclairage de sécurité. Ces interrupteurs sont d'une part tous deux reliés à la masse et d'autre part l'un à l'entrée de déclenchement 31 du compteur de temps et l'autre a la sortie complémentée 21 du circuit de gestion de bloc. La fermeture de ces deux interrupteurs simule simultanément la mise en condition des transistors 170 et 383 (figures 2 et 3), pour assurer le déclenchement du compteur de temps 30 et la fermeture de l'interrupteur commandé 14. Ces interrupteurs peuvent être, par exemple, des éléments photosensibles (commande par rayonnement lumineux), des micro-interrupteurs (commande manuelle), des interrupteurs à lame souple (commande magnétique), des interrupteurs horaires (commande temporelle) etc...

Il est également possible de modifier certaines dispositions des tests d'autonomie. Ainsi que représenté dans la figure 7, on peut couper la charge batterie durant le test afin de réaliser un test en vraie grandeur, à l'aide d'un circuit d'entrée 12' du circuit 12 de charge fonctionnant en interrupteur normalement fermé qui est commandé en ouverture avec le circuit de simulation 36. Ce circuit d'entrée est constitué par deux transistors l'un PNP 126 et l'autre NPN 127.

Le transistor 127, monté en émetteur commun est commandé par la sortie d'état 33 du compteur de temps à travers un inverseur 128, son collecteur est relié à la base du transistor 126. Ce transistor 126 a son émetteur relié à la sortie du circuit d'alimentation 10 et son collecteur au pont résistif 121, 122 du circuit de charge 12 (figure 2).

En fonctionnement, un niveau logique 0 sur la sortie 33, pour lequel le circuit de simulation est bloqué en l'absence de test d'autonomie provoque la mise en conduction du transistor 127 qui rend également conducteur le transistor 126. Dans ces conditions d'absence de test, la batterie d'accumulateurs est normalement chargée. Le niveau logique 1 sur la sortie 33, pour lequel le circuit de simulation simule une coupure de l'alimentation normale durant le test, provoque à travers l'inverseur le blocage du transistor 127 qui assure le blocage du transistor 126 coupant alors la charge batterie pour la durée du test.

**Revendications**

1. Dispositif de test d'autonomie pour bloc d'éclairage de sécurité (1) comportant au moins une lampe de sécurité (130), une batterie d'accumulateurs (11) destinée à alimenter la lampe de sécurité (130), un circuit (12) de charge de la batterie d'accumulateurs (11) connecté à une alimentation dite normale (2) dont la coupure doit entraîner l'allumage du bloc d'éclairage de sécurité (1), un interrupteur commandé (14) connectant la lampe de sécurité (130) aux bornes de la batterie d'accumulateurs (11) et un dispositif de gestion de bloc (15) contrôlant l'interrupteur commandé (14) et le fermant lorsque l'alimentation normale (2) disparaît et que la batterie d'accumulateurs (11) délivre une tension supérieure à un seuil minimum, ledit dispositif de test (3) comportant un compteur de temps déclenchable (30) et étant caractérisé en ce qu'il comporte en outre un circuit de réception d'ordre de test d'autonomie (38) accessible par une entrée de télécommande (18) qui est commune au dispositif de gestion de bloc (15) et qui permet à la fois de télécommander l'extinction et le réallumage du bloc d'éclairage pendant une coupure de l'alimentation normale et, à l'aide d'un ordre spécifique, de déclencher le compteur de temps (30), un circuit de simulation (36) contrôlé par le compteur de temps (30) qui, pendant le fonctionnement de ce dernier simule, pour le circuit de gestion de bloc (15), une coupure de l'alimentation normale (2), et un circuit de visualisation de la durée de fonctionnement du compteur de temps (30) en l'absence d'une ouverture de l'interrupteur commandé (14).

2. Dispositif de test d'autonomie selon la revendication 1, pour bloc d'éclairage de sécurité (1) présentant une entrée de télécommande (18) sensible à des impulsions de polarités opposées, l'une provoquant son extinction et l'autre son réallumage pendant une coupure de l'alimentation normale (2), caractérisé en ce que le circuit de réception d'ordre de test d'autonomie (38) est un discriminateur à seuil d'amplitude détectant des impulsions de même polarité mais d'amplitude supérieure à celles provoquant le réallumage du bloc.

3. Dispositif de test d'autonomie selon la revendication 1, pour bloc d'éclairage de sécurité (1) présentant une entrée de télécommande (18) sensible à des impulsions provoquant soit l'extinction soit le réallumage du bloc d'éclairage de sécurité (1) pendant une coupure de l'alimentation normale (2), caractérisé en ce que le circuit de réception d'ordre de test d'autonomie (38) est un discriminateur à seuil de durée, ledit seuil ayant une valeur supérieure à la durée des impulsions provoquant le réallumage du bloc.

4. Dispositif de test d'autonomie selon la revendication 1, pour bloc d'éclairage de sécurité (1) présentant une entrée de télécommande (18) sensible à des impulsions provoquant soit l'extinction soit le réallumage du bloc d'éclairage de sécurité (1) pendant une coupure de l'alimentation normale (2), caractérisé en ce que le circuit de réception d'ordre de test d'autonomie est sensible à une tension alternative.

5. Dispositif de test d'autonomie selon la revendication 1, caractérisé en ce que le compteur de temps (30) est pourvu d'un circuit d'alimentation (39) branché sur l'alimentation normale (2) et secouru par la batterie d'accumulateurs (11) du bloc d'éclairage de sécurité (1).

6. Dispositif de test d'autonomie selon la revendication 2, caractérisé en ce que le compteur de temps (30) comporte:

- une bascule bistable de type R̄ S̄ (306, 307) dont l'entrée S̄ constitue une entrée de déclenchement, et l'entrée R̄ une entrée de blocage,
- un oscillateur (304, 305) pourvu d'une entrée d'autorisation active au niveau logique 1 connectée à la sortie Q de la bascule de type R̄ S̄ (306, 307),
- un compteur numérique (300) avec une entrée de comptage (301) connectée à la sortie de l'oscillateur (304, 305), une entrée de remise à zéro (302) connectée par l'intermédiaire d'un circuit différentiateur (309, 308) à la sortie Q de la bascule de type R̄ S̄ (306, 307) et une sortie de visualisation passant d'un niveau logique 0 à 1 au bout de la durée d'un test,
- et une porte logique de type "non ou" (37) à deux entrées connectée en sortie à l'entrée R̄ de la bascule bistable de type R̄ S̄ (306, 307) et en entrée d'une part à la sortie de visualisation du compteur numérique (300) et d'autre part à une sortie 21 du dispositif de gestion de bloc (15) passant au niveau logique 0 lorsque l'interrupteur commandé (14) est ouvert et au niveau logique 1 dans le cas inverse.

7. Dispositif de test d'autonomie selon la revendication 2, pour bloc d'éclairage de sécurité (1) présentant une entrée de télécommande (18) sensible à des impulsions provoquant pendant une coupure de l'alimentation normale (2) une extinction du bloc d'éclairage de sécurité (1) lorsqu'elles sont négatives et un réallumage lorsqu'elles sont positives, caractérisé en ce que le circuit de réception d'ordre de test d'autonomie (38) comporte un transistor de type NPN (383) monté en émetteur commun, avec sa base connectée au point milieu d'un pont diviseur résistif (380, 381) placé entre la masse et l'entrée de télécommande (18) du bloc d'éclairage de sécurité (1).

8. Dispositif de test d'autonomie selon la revendication 4, caractérisé en ce que le circuit de réception d'ordre de test d'autonomie (38) comporte en entrée un redresseur doubleur de tension (385, 386, 387, 388).

9. Dispositif de test d'autonomie selon la revendication 1, caractérisé en ce qu'il présente des éléments de commande locale ou rapprochée (321, 331) fonctionnant en interrupteurs normalement ouverts en l'absence de test et commandés en fermeture momentanée au déclenchement d'un test d'autonomie pour assurer alors le déclenchement du compteur de temps (30) et la fermeture de l'interrupteur commandé (14).

10. Dispositif de test d'autonomie selon la revendication 6, caractérisé en ce que la sortie Q de ladite bascule de type R̄ S̄ (306, 307) est reliée à un circuit d'entrée (12') du circuit (12) de charge de la batterie, coupant la charge de celle-ci pendant la durée d'un test d'autonomie.

**Patentansprüche**

1. Vorrichtung zur Prüfung der Autonomie eines Notbeleuchtungsblocks (1), der mindestens eine Notleuchte (130), eine Akkumulatorenbatterie (11) zur Stromversorgung der Notleuchte (130), eine Schaltung (12) zum Laden der Akkumulatorenbatterie, die an ein normales Stromversorgungsnetz (2) angeschlossen ist, dessen Ausfall die Einschaltung des Notbeleuchtungsblocks (1) bewirken soll, einen gesteuerten Schalter (14), der die Notleuchte (130) mit den Klemmen der Akkumulatorenbatterie (11) verbindet, und eine Blocksteuervorrichtung (15) aufweist, die den gesteuerten Schalter (14) überwacht und ihn schließt, wenn das normale Stromversorgungsnetz (2) ausfällt, und wenn die Akkumulatorenbatterie (11) eine Spannung oberhalb einer Mindestschwelle liefert, wobei die Prüfvorrichtung (3) einen auslösbaren Zeitzähler (30) aufweist und dadurch gekennzeichnet ist, daß sie weiter eine Schaltung (38) zum Empfang eines Autonomieprüfbefehls, die über einen Fernsteuereingang (18) zugänglich ist, welcher zur Blocksteuervorrichtung (15) gehört und sowohl die Fern-Abschaltung als auch die Fern-Wiedereinschaltung des Beleuchtungsblocks während eines Ausfalls des normalen Stromversorgungsnetzes sowie, mit Hilfe eines speziellen Befehls, die Auslösung des Zeitzählers (30) erlaubt, eine vom Zeitzähler (30) gesteuerten Simulationsschaltung (36), welche während des Zählerbetriebs für die Blocksteuerschaltung (15) eine Unterbrechung der normales Stromversorgungsnetz (2) simuliert, und einer Schaltung (30) zur Anzeige der Betriebsdauer des Zeitzählers (30) aufweist, so lange der gesteuerte Schalters (14) nicht geöffnet ist.

2. Vorrichtung zur Prüfung der Autonomie nach Anspruch 1 für einen Notbeleuchtungsblock (1), mit einem Fernsteuereingang (18), der auf Impulse beider Polaritäten anspricht, von denen die eine Polarität die Ausschaltung und die andere die Wiedereinschaltung des Blocks während des Ausfalls des normalen Stromversorgungsnetzes (2) verursacht, dadurch gekennzeichnet, daß die Schaltung (38) zum Empfang des Autonomieprüfbefehls aus einem Diskriminator mit Amplitudenschwelle besteht, der Impulse mit gleicher Polarität, aber größerer Amplitude als derjenigen erfaßt, welche die Wiedereinschaltung der Block veranlassen.

3. Vorrichtung zur Prüfung der Autonomie nach Anspruch 1 für einen Notbeleuchtungsblock (1), mit einem Fernsteuereingang (18), der auf Impulse anspricht, welche entweder die Ausschaltung oder die Wiedereinschaltung des Notbeleuchtungsblocks (1) während des Ausfalls des normalen Stromversorgungsnetzes (2) verursachen, dadurch gekennzeichnet, daß die Schaltung (38) zum Empfang des Autonomieprüfbefehls aus einem Diskriminator mit Zeitschwelle besteht, deren Schwellwert größer als die Dauer der die Wiedereinschaltung des Blocks veranlassenden Impulse ist.

4. Vorrichtung zur Prüfung der Autonomie nach Anspruch 1 für einen Notbeleuchtungsblock (1), mit einem Fernsteuereingang (18), der auf Impulse anspricht, die entweder die Ausschaltung oder die Wiedereinschaltung des Notbeleuchtungsblocks (1) während des Ausfalls des normalen Stromversorgungsnetzes (2) verursachen, dadurch gekennzeichnet, daß die Schaltung (38) zum Empfang des Autonomieprüfbefehls auf eine Wechselspannung anspricht.

5. Vorrichtung zur Prüfung der Autonomie nach Anspruch 1, dadurch gekennzeichnet, daß der Zeitzähler (30) mit einer an das normale Stromversorgungsnetz (2) angeschlossenen Stromversorgungsschaltung (39) ausgestattet ist und durch die Akkumulatorenbatterie (11) des Notbeleuchtungsblocks (1) im Notfall versorgt wird.

6. Vorrichtung zur Prüfung der Autonomie nach Anspruch 2, dadurch gekennzeichnet, daß der Zeitzähler (30) folgende Komponenten aufweist:

- eine bistabile Kippschaltung vom Typ RS (306, 307), deren S-Eingang einen Auslöseeingang, und deren R-Eingang einen Blockiereingang bildet,
- einen Oszillator (304, 305) mit einem aktiven Freigabeeingang auf Logikpegel 1, der an den Ausgang Q der Kippschaltung vom Typ RS (306, 307) angeschlossen ist,
- einen Digitalzähler (300), mit einem an den Ausgang des Oszillators (304, 305) angeschlossenen Zähleingang (301), einem Nullrückstelleingang (302), der über eine Differenzierschaltung (309, 308) an den Ausgang Q der Kippschaltung vom Typ RS (306, 307) angeschlossen ist, und einem Anzeigeausgang, der am Ende der Prüfdauer von Logikpegel 0 nach 1 geht, und
- ein logisches NOR-Gatter (37) mit zwei Eingängen, das ausgangsseitig an den Eingang R der bistabilen Kippschaltung vom Typ RS (306, 307) und eingangsseitig zum einen an den Anzeigeausgang des Digitalzählers (300) und andererseits an einen Ausgang (21) der Blocksteuervorrichtung (15) angeschlossen ist, welcher auf Logikpegel 0 übergeht, wenn der gesteuerte Schalter (14) geöffnet ist, und auf Logikpegel 1 im entgegengesetzten Fall.

7. Vorrichtung zur Prüfung der Autonomie nach Anspruch 2, für einen Notbeleuchtungsblock (1), mit einem Fernsteuereingang (18), der auf Impulse anspricht, die während der Dauer des Ausfalls des normalen Stromversorgungsnetzes (2) eine Abschaltung des Notbeleuchtungsblocks (1) veranlassen, wenn die Impulse negativ sind, und eine Wiedereinschaltung, wenn sie positiv sind, dadurch gekennzeichnet, daß die Schaltung (38) zum Empfang des Autonomieprüfbefehls einen NPN-Transistor (383) in Emitterschaltung aufweist, dessen Basis an den Zwischenabgriff einer Widerstandsteilerbrücke (380, 381) angeschlossen ist, die zwischen Erde und dem Fernsteuereingang (18) des Notbeleuchtungsblocks (1) geschaltet ist.

8. Vorrichtung zur Prüfung der Autonomie nach Anspruch 4, dadurch gekennzeichnet, daß die Schaltung (38) zum Empfang des Autonomieprüfbefehls eingangsseitig eine Gleichrichter-Spannungsverdopplerschaltung (385, 386, 387, 388) aufweist.

9. Vorrichtung zur Prüfung der Autonomie nach Anspruch 1, dadurch gekennzeichnet, daß sie örtliche oder in geringer Entfernung liegende Steuerelemente (321, 331) aufweist, die als normalerweise offene Schalter dienen, solange keine Prüfung erfolgt, und zum kurzzeitigen Schließen bei der Einleitung einer Autonomieprüfung veranlaßt werden, um dann die Auslösung des Zeitzählers (30) und die Schließung des gesteuerten Schalters (14) zu bewirken.

10. Vorrichtung zur Prüfung der Autonomie nach Anspruch 6, dadurch gekennzeichnet, daß der Ausgang Q der Kippschaltung vom Typ RS (306, 307) mit einem Eingangskreis (12') der Batterieladeschaltung (12) verbunden ist, welcher das Laden der Batterie während der Dauer einer Autonomieprüfung unterbricht.

## Claims

1. An endurance test device for an emergency lighting unit (1) including at least one emergency lamp (130), a battery of rechargeable cells (11) for powering the emergency lamp (130), a charging circuit (12) for the battery (11) connected to a "normal" power supply (2), a failure in which should cause the emergency lighting unit (1) to be switched on, a controlled switch (14) which connects the emergency lamp (130) across the terminals of the battery (11), and a unit management circuit which controls the controlled switch and which closes it if the normal power supply (2) disappears while the battery (11) is delivering a voltage above a minimum threshold, said test device (3) including a triggerable period counter (30) and being characterised in that it further includes:
    an endurance test command receiver circuit (38) operable by a remote control input (18) which is common to the unit management circuit (15) and which allows the lighting unit to be switched off and switched on again by remote control during a failure in the normal power supply and which also allows the period counter (30) to be triggered by means of a specific command;
    a simulation circuit (36) controlled by the period counter (30) and which, when the counter is running, simulates to the unit management circuit (15) a failure in the normal power supply (2); and
    a circuit which displays the duration of operation of the period counter (30) if the controlled switch (14) does not open.

2. An endurance test device according to claim 1, for an emergency lighting unit (1) having a remote control input responsive to pulses of opposite polarity, one polarity switching the unit off and the other switching it on again during a failure in the normal power supply, said test device being characterised in that the endurance test command receiver circuit (38) is a threshold amplitude discriminator which detects pulses of the same polarity but of greater amplitude than those which cause the unit to be switched on again.

3. An endurance test device according to claim 1, for an emergency lighting unit (1) having a remote control input (18) responsive to pulses causing the emergency lighting unit (1) to be switched off or switched on again during a failure in the normal power supply (2), said test device being characterised in that the endurance test command receiver circuit (38) is a threshold duration discriminator, said threshold having a value greater than that of the pulses which cause the unit to be switched on again.

4. An endurance test device according to claim 1, for an emergency lighting unit (1) having a remote control input (18) responsive to pulses causing the emergency lighting unit (1) to be switched off or switched on again during a failure in the normal power supply (2), said test device being characterised in that the endurance test command receiver circuit is responsive to an alternating voltage.

5. An endurance test device according to claim 1, characterised in that the period counter (30) is provided with a supply circuit (39) connected to the normal power supply (2) and backed up by the battery (11) of the emergency lighting unit (1).

6. An endurance test device according to claim 2, characterised in that the period counter (30) comprises:

– a bistable R̄-S̄ flip-flop (306, 307) whose S̄ input constitutes a trigger input and whose R̄ input constitutes an inhibit input,
– an oscillator (304, 305) having an enable input responsive to logic level 1 which is connected to the Q output of the R̄-S̄ flip-flop,
– a digital counter (300) with a count input (301) connected to the output of the oscillator (304, 305), a reset-to-zero input (302) connected via a differentiator circuit (309, 308) to the Q output of the R̄-S̄ flip-flop (306, 307) and a display output which changes from logic level 0 to logic level 1 at the end of the test duration, and
– a two-input gate (37) whose output is connected to the R̄ input of the bistable R̄-S̄ flip-flop (306, 307) and whose inputs are connected to the display output of the digital counter (300) and to an output (21) of the unit management device (15), this output having a logic level 0 when the controlled switch (14) is open and a logic level 1 in the opposite case.

7. An endurance test device according to claim 2, for an emergency lighting unit (1) having a remote control input (18) responsive to pulses which, during a failure in the normal power supply (2), cause the emergency lighting unit (1) to be switched off if of negative polarity and cause the unit to be switched on again if of positive polarity, the test device being characterised in that the endurance test command receiver circuit (38) comprises a common-emitter connected NPN transistor (383) whose base is connected to the mid-point of a resistive divider bridge (380, 381) situated between earth and the remote control input (18) of the emergency lighting unit.

8. An endurance test device according to claim 4, characterised in that the endurance test command receiver circuit (38) has a voltage doubling

19

rectifier (385, 386, 387, 388) on its input.

9. An endurance test device according to claim 1, characterised in that it has local or semi-local control elements (321, 331) which function as normally-open switches when there is no test and which are given momentary closing commands when an endurance test is initiated so as to ensure triggering of the period counter (30) and closing of the controlled switch (14).

10. An endurance test device according to claim 6, characterised in that the Q output of said R̄-S̄ flip-flop (306, 307) is connected to an input circuit (12') of the battery charging circuit (12) so as to prevent charging of the battery for the duration of an endurance test.

# FIG.1

EP 0 171 629 B1

FIG.2

FIG.3

# FIG.4

# FIG.5

# FIG.6

# FIG.7